# EUROPEAN PATENT APPLICATION

(11) **EP 0 730 266 A2**
(43) Date of publication of application: **04.09.1996**
(21) Application number: 95105143.2
(22) Date of filing: 05.04.1995
(51) Int. Cl.: G11B 5/84

(54) **Apparatus for plasma-processing a disk substrate and method of manufacturing a magnetic disk**

(30) Priority: 06.02.1995 JP 17682/95
(71) Applicant: HITACHI, LTD., Chiyoda-ku, Tokyo 101 (JP)
(72) Inventor: Kokaku, Yuichi, Yokohama-shi (JP); Inaba, Hiroshi, Yokohama-shi (JP); Sasaki, Shinji, Totsuka-ku, Yokohama-shi (JP); Kataoka, Hiroyuki, Naka-gun, Kanagawa-ken (JP); Honda, Yoshinori, 1007-1, Shinomiya, Hiratsuka-shi (JP); Terakado, Masatomo, Odawara-shi (JP); Furusawa, Kenji, Totsuka-ku, Yokohama-shi (JP)
(74) Representative: Strehl Schübel-Hopf Groening & Partner

(57) **Abstract**

A continuous electrode (5) entirely held at substantially the same potential is disposed in a plasma processing chamber (4) to define the inner wall thereof. A disk substrate (1) is placed in the electrode, and a plasma is generated around the disk substrate in a uniform state. A cross-sectional area of the plasma extending over the upper and lower surfaces of the disk substrate is made larger than a combined area of the disk substrate and its holder (2). The plasma uniformly surrounds the outer periphery and a central hole of the disk substrate. Further, a gas exhaust system (10, 32, 33, 331) for exhausting a reactive gas from the plasma processing chamber is made up of a main exhaust path (10) and a bypass exhaust path (33) such that the bypass exhaust path is used to exhaust the reactive gas at a stroke from the plasma processing chamber after plasma processing has been performed on the disk substrate, thus reducing a time required to exhaust the reactive gas. This structure enables a diamond-like carbon (DLC) protective film (36) to be uniformly formed on both surfaces of the disk substrate while improving the productivity of magnetic disk substrates.

## Description

### BACKGROUND OF THE INVENTION

The present invention relates generally to a plasma processing apparatus and method, and more particularly to a plasma processing apparatus and method for performing plasma processing uniformly and simultaneously on both surfaces of a disk substrate.

The present invention is also directed to a method and apparatus for manufacturing a magnetic disk medium, and more particularly to a method and apparatus for forming a diamond-like carbon coating on a disk substrate by plasma processing in order to reliably manufacture magnetic disks with a good mass-productivity.

A disk substrate, for example, used for a magnetic disk drive has a variety of functional thin films laminated on the surface thereof. Techniques applied to the formation of these thin films, are introduced from those which have been mainly developed for the manufacturing processes for wafers used for semiconductor devices, such as sputtering, vacuum vapor deposition, and so on. However, since the wafers are generally plain, and only one of plain surfaces of each wafer is subjected to the processes, simple methods for holding and carrying these wafers are sufficient for the wafer processing facilities. In contrast, a disk substrate is formed in a central portion thereof with a chucking hole used for mounting the disk substrate in a disk drive. Moreover, a magnetic disk and so on are normally used in such a manner that information is recorded on both surfaces thereof. It is therefore critical to provide the disk substrate with layers having uniform characteristics on both surfaces thereof.

Recently, for responding to requirements of smaller magnetic disk drives and higher recording density of media, there is a tendency to more effectively utilize the disk surfaces. As such a means, regions as close as possible to the inner and outer peripheries on both surfaces of a disk have been utilized as a user area. Thus, the requirement to the uniformity of layers on both surfaces of disks is becoming more strict.

In addition, the employment of new processes is also desired for improving the performance of the disks. For example, new techniques have been in consideration for cleaning disk substrates by plasma etching before the formation of films thereon, forming a diamond-like carbon (DLC) protective film on a substrate by plasma CVD (Chemical Vapor Deposition), and so on. Particulary, for magnetic disks, attempts have been made to reduce the spacing between a recording and reproducing magnetic head element and a magnetic film as much as possible in order to enhance the recording density of the magnetic disk. In response to these attempts, the thickness of a protective layer on a magnetic disk tends to be made as thin as possible. It is known that DLC plays an important role for achieving the possible thinnest protective layer. This is because DLC is so hard that high wear durability is provided even with a reduced thickness. In addition, DLC is also excellent in corrosion durability because of its good coverage accomplished by utilizing a high bias voltage.

However, for applying the plasma CVD to the formation of films on a magnetic disk, there remain a variety of problems which must be solved as follows.

First, in a normal DLC film forming method, a high-frequency high voltage is applied to a substrate, on which a film is to be formed, to form a dense and hard DLC film on the substrate by forcing positive ions in a hydrocarbon plasma to acceleratively collide with the substrate by a negative bias voltage generated around the substrate. Therefore, under plasma conditions in which a high bias voltage is not applied, this method can only provide a so-called plasma polymerized film or polymer film. However, generally in magnetic disk manufacturing processes, multi-layer films are successively formed on sequentially carried substrates in view of productivity. Thus, the application of a high voltage to substrates in such a manufacturing environment would be difficult to realize.

Second, since a disk substrate is used for recording up to the vicinity of the inner and outer peripheries, chucking of the disk substrate is not easy.

Third, in a central hole of the disk, a plasma tends to loose uniformity, which not only causes a degraded film thickness distribution but also occasionally decreases the bias voltage to hinder the formation of a DLC film if the plasma concentrates in the central hole.

Fourth, a formed DLC film may often differ in thickness and quality on one and the other surfaces of a disk.

Fifth, since a disk substrate is mechanically held and is applied with a voltage during manufacturing, the disk substrate is not partially covered with a film due to such operations. If a wide area of the disk is not covered with the film, a metal thin film serving as a magnetic film is exposed. This would cause corrosion of the exposed metal thin film or direct contact of the exposed portion with a magnetic head, which would consequently give rise to scratches on the exposed metal thin film.

To deal with the problems mentioned above, the present inventors and others have proposed techniques of utilizing a predetermined electrode structure to form a DLC film on a substrate which is held at a ground potential, as described, for example, in JP-A-3-120362 and JP-A-63-206471. According to these methods, by utilizing an electrode having large areas as compared with a substrate and a substrate holder, a high negative bias voltage can be generated even for the substrate at the ground potential. Stated another way, a plasma potential is regarded as a large positive potential relative to the substrate. This technique takes advantage of the principle of self-bias generation of high frequency plasma. It is thought that the first and second problems will substantially be solved by this method.

Alternatively, a substrate can be applied with a high-frequency high voltage as the case may be. While an introducing portion of a high voltage must be designed with special attention for the application of a high frequency high voltage to substrates, it is not impossible to use this technique together with other film forming processes.

Solution of the third problem, however, is difficult. An example which has overcome the third problem is described in J. Bartella et al "PECVD Carbon Overcoat for Magnetic Media", 37th Annual Technical Conference Proceedings (1944); Society of Vacuum Coaters 505 1856-7188. A method employed in this example utilizes a very low gas pressure at approximately 2 mTorr and applies a magnetic field parallel to the surface of a disk substrate to avoid the concentration of a plasma in a hole of the disk substrate. However, since this method utilizes a low gas pressure, a film forming speed is lower. The techniques described in the aforementioned documents utilize acetylene as a reactive gas to improve the film forming speed, and certain contributions are recognized to be made to the film forming speed. Unfortunately, a problem associated with the use of acetylene appears to be that carbon-to-carbon double coupling is easily formed to often result in a film having the structure close to graphite. Further, the fourth and fifth problems remain unsolved. Particularly, as to the fourth problem, the aforementioned documents also note that it is still unsolved.

As described above, in deep consideration of the formation of a DLC film on a disk substrate in a mass productive manner, no appropriate film forming apparatuses have been proposed for solving all the above problems, which is a bottleneck for practically forming a DLC film on disk substrates.

### SUMMARY OF THE INVENTION

It is an object of the present invention to provide a plasma processing method and apparatus which can form a uniform film on a subject under processing.

It is another object of the present invention to provide a plasma processing method and apparatus which can form uniform films on both surfaces of a disk substrate.

It is a further object of the present invention to provide a disk manufacturing apparatus and method which can form a diamond-like carbon (DLC) film on a disk substrate having a hole formed in a central portion thereof, wherein the film is made uniform particularly in an outer peripheral portion and in the vicinity of the hole.

It is a further object of the present invention to provide a plasma processing method and apparatus which can perform plasma processing with improved productivity of subjects under processing.

The present inventors and others have made attempts to achieve the above objects by mainly improving an electrode structure disposed in a plasma processing chamber, the construction of the periphery including the processing chamber itself, and a method of manufacturing a disk substrate in the processing chamber.

More specifically, the present invention provides the plasma processing chamber with an electrode which is entirely held at substantially the same potential and has a sufficient space therein such that a disk substrate or a subject under processing is loosely accommodated. The disk substrate is held at a ground potential, and a high-frequency voltage is applied to the electrode to generate a plasma such that the entire surfaces of the disk substrate are surrounded by the plasma. When the subject under processing is a disk substrate having a hole in a central portion thereof, the term "entire surfaces" used herein should be understood to include not only plain portions of both upper and lower surfaces but also outer and inner peripheral end portions of the disk substrate. Since the disk substrate is held by any holder, a part of the disk substrate is in contact with the holder. Preferably, such a contact portion is as small as possible.

In a preferable plasma processing apparatus according to the present invention, the electrode disposed in the plasma processing chamber is, for example, made of a metal and has a box-like shape in order to accommodate a subject under processing and perform the plasma processing therein. The plasma processing apparatus also comprises a power supply for generating a high-frequency high voltage to be applied to the electrode; a conductive holder for holding the subject under processing and formed to be at the ground potential commonly with the subject under processing; a carrier mechanism for carrying the holder in order to access the subject under processing together with the holder to the plasma processing chamber; a gas introducing system for supplying the plasma processing chamber with a reactive gas including, for example, hydrocarbon; and an exhaust system for exhausting the reactive gas from the plasma processing chamber.

For example, when a large number of magnetic disks are manufactured, each time a disk substrate is plasma-processed, the carrier mechanism accesses the disk substrate to the plasma processing chamber, the power supply applies a high voltage to the electrode, the gas introducing system supplies the reactive gas to the plasma processing chamber, and the exhaust system exhausts the reactive gas from the plasma processing chamber. These operations are repeated for every disk substrate to be plasma-processed.

When a disk substrate is placed in the box-like electrode for simultaneously plasma-processing both surfaces thereof, it is preferable that the size of the electrode is selected such that, in a plane including the center of the disk substrate defined by a plane parallel to the surface of the disk substrate inside the electrode, a total cross-sectional area occupied by a plasma is made larger than a total area of the disk substrate and a conductor portion at the same potential as the disk substrate. The conductor portion at the same potential as the disk substrate includes, for example, the holder. According to this structure, since the electrode has a sufficiently wide area as compared with the area of the disk substrate, and the entire electrode is held at the same potential, a plasma is generated in substantially a uniform state even in the central hole and in an outer peripheral end portion of the disk substrate to be processed.

In this way, according to the present invention, the disk substrate is surrounded by the electrode held at the same potential, a generated plasma is integrated to the utmost, substantially an equal potential prevails over both surfaces of the disk substrate, and moreover a potential difference is negligible in the vicinity of inner and outer peripheral portions and on both surfaces of the disk substrate. It is therefore possible to form a more uniform DLC film in terms of thickness and properties on both surfaces of the substrate as well as to form a homogeneous DLC film on the inner peripheral portion bordering on the central hole and on the outer peripheral portion of the disk substrate.

Preferably, the electrode is formed on the inner surface thereof with a layer of an insulating material having covalent coupling of carbon as an inner wall protective layer. The insulating material may be polyimide or insulating SiC. This protective layer protects the electrode from being directly damaged by a plasma and prevents films from being deposited on the inner wall of the electrode during the formation of the DLC film.

The exhaust system includes a main exhaust path for normally exhausting a reactive gas from the plasma processing chamber, a valve operable to open and close, a bypass exhaust path constituting a part of the electrode. A slight amount of gas is exhausted through the main exhaust path even while the plasma processing is under way in the plasma processing chamber. When the plasma processing is completed, the valve is opened to exhaust the reactive gas at a stroke from the plasma processing chamber. The performance of the bypass exhaust path allows a reduction in time required to exhaust the reactive gas as well as an improvement in the productivity of disk substrates. Also, since the reactive gas can be more fully exhausted from the plasma processing chamber, the reactive gas, which would otherwise remain in the plasma processing chamber, will never flow into other processing chambers such as a sputtering chamber. This results in preventing degraded films which may be formed on the disk substrate in the other processing chambers.

A magnetic disk according to the present invention is preferably manufactured by executing the steps of heating a non-magnetic disk substrate having a hole in a central portion thereof; sputter-forming an underlying layer on the disk substrate; sputter-forming a magnetic layer on the underlying layer; generating a plasma with a reactive gas controlled under a predetermined condition to form a protective layer on the magnetic layer; and forming a lubricative layer on the protective layer. In particular, the plasma is generated preferably under conditions that the disk substrate is heated to temperatures ranging from a room temperature to 350°C, a gas pressure ranges from 10 to 500 mTorr, a plasma potential for the disk substrate ranges from 100 to 1500 volts. The generated plasma surrounds the disk substrate, substantially without producing a potential difference in the vicinity of an inner peripheral portion bordering on the central hole and an outer peripheral portion and along the upper and lower surfaces of the substrate, to form a homogeneous DLC film on the upper and lower surfaces and inner and outer peripheral portions of the disk substrate.

### BRIEF DESCRIPTION OF THE DRAWINGS

Fig. 1 is a side view showing a plasma processing apparatus according to one embodiment of the present invention;
Fig. 2 is a cross-sectional view taken from the right of Fig. 1, cut along a plane parallel to the surface of a disk substrate for illustrating the interior of a box-like electrode;
Fig. 3 is a partially cut-away perspective view showing the structure of the plasma processing apparatus of Fig. 1;
Fig. 4 is a flow chart showing an example of a DLC film forming method according to one embodiment of the present invention;
Fig. 5 is a diagram showing the structure of a magnetic disk manufacturing apparatus according to one embodiment of the present invention;
Figs. 6A - 6E each show a manufacturing process of a magnetic disk and a cross-section of a disk at each process;
Fig. 7 shows an outer appearance and a partial cross-section of a magnetic disk medium according to one embodiment of the present invention;
Fig. 8 is a graph showing a film thickness distribution of a DLC film formed on a disk substrate according to one embodiment of the present invention;
Fig. 9 is a graph showing a film thickness distribution of a DLC film formed on a 2.5-inch disk substrate according to one embodiment of the present invention;
Fig. 10 is a graph showing film thickness distributions of DLC films formed on disks using another electrode according to the present invention;
Fig. 11 is a graph showing a film thickness distribution of a DLC film when formed on a disk substrate under conditions not relying on the present invention;
Fig. 12 is a graph showing the relationship between a number of foreign substances attached on the surfaces of disk substrates and an accumulated number of disk substrates which have undergone the film formation processing, when the inner wall of the plasma processing chamber is covered respectively with layers of different materials;
Fig. 13 is a graph showing a change in film thickness distribution when a ratio of the radius of a hole of a disk to the width of a sheath of a plasma is varied;
Fig. 14 is a diagram showing the structure of an attachment disposed around the outer periphery of a disk substrate for placing the same in a plasma processing chamber according to another embodiment of the present invention; and
Fig. 15 is a graph showing a film thickness distribution of a DLC film formed on a disk substrate according to another embodiment of the present invention.

### DESCRIPTION OF THE PREFERRED EMBODIMENTS

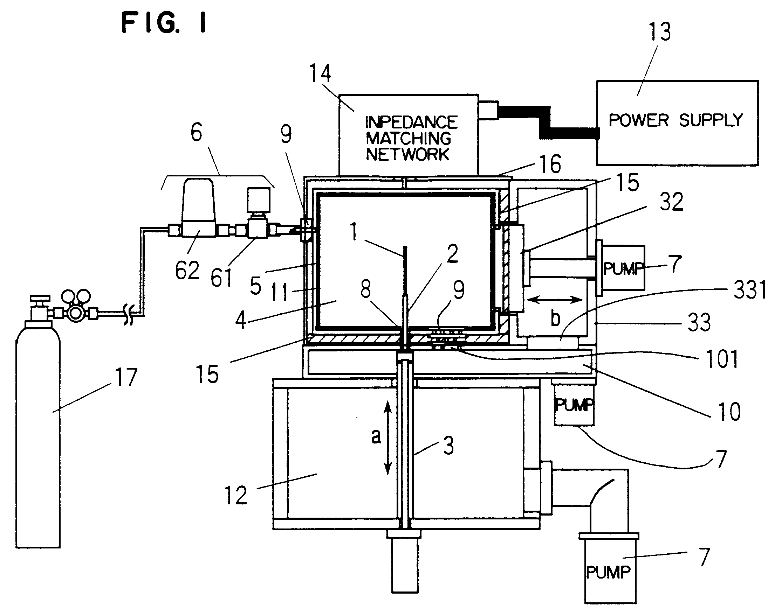

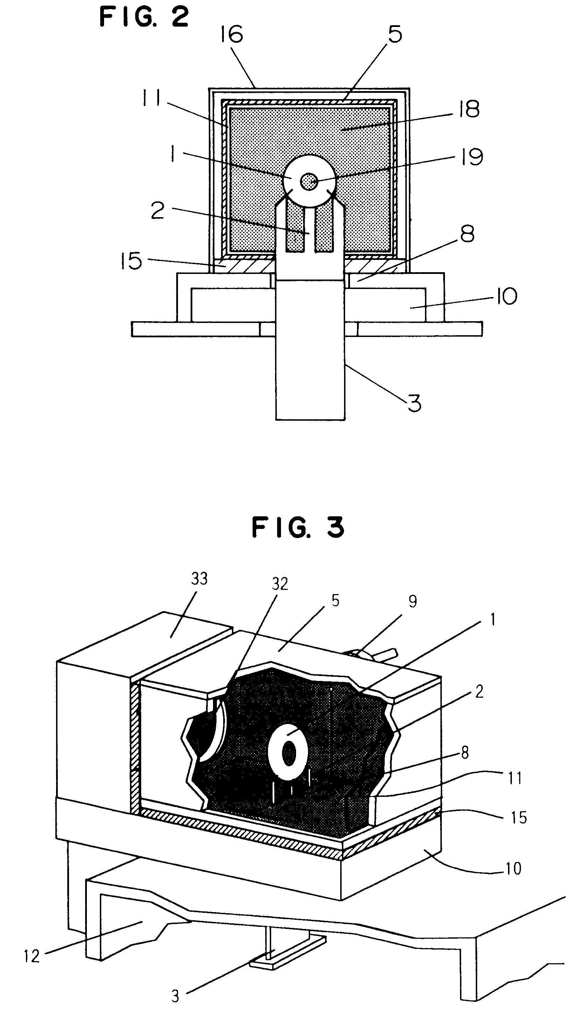

One embodiment of the present invention will hereinafter be described with reference to Figs. 1 - 3. Fig. 1 is a side view showing the internal structure of a plasma processing apparatus according to the present invention; Fig. 2 is a cross-sectional view taken from the right of Fig. 1; and Fig. 3 is a perspective view of the plasma processing apparatus.

A disk substrate 1 under processing may be, for example, a disk-like substrate made of aluminum having a hole in a central portion thereof, similar to a magnetic disk medium. The disk substrate 1 has magnetic recording layers made of cobalt/chrome formed on both surfaces thereof. A DLC film is formed on this substrate 1. The outer periphery of the substrate 1 is partially contacted to and held by a holder 2. The holder 2, made of a metal, as well as the disk substrate 1 are at a ground potential and mounted on a carrier mechanism 3. The carrier mechanism 3 drives the holder 2 in the directions indicated by the arrows a in order to carry the disk substrate 1 between a main vacuum chamber 12 and a plasma processing chamber 4. The disk substrate 1 is set in the processing chamber 4 in this way.

The plasma processing chamber 4 has, for example, a box-like shape. Inside the plasma processing chamber 4, a box is formed by a metal electrode 5 which is surrounded by an earth cover 16. A spacing is formed between the electrode 5 and the earth cover 16 to provide an insulating function therebetween. One feature of the present invention lies in the structure of the electrode 5 and the relationship between the electrode 5 and its peripheral structure. Characteristic portions including this structure will be described later in detail.

The electrode 5 is connected to a power supply 13 through an impedance matching network 14, such that the electrode 5 is applied with a high-frequency high voltage from the power supply 13. Around the box-like electrode 5, an insulating layer 15 and the earth cover 16 are provided for ensuring the security and removing noise.

The box-like electrode 5 is provided with an access port 8 for the substrate 1 as well as an inlet and an outlet for connection with a gas introducing system 6 and a gas exhaust system 10, 33. At the boundary between the gas introducing system 6 and the electrode 5 and at the boundary between the main exhaust path 10 and the electrode 5, a slit-like plasma blocking member 9 is provided in order to prevent a plasma in the plasma processing chamber 4 from extending to the gas introducing system 6 or to the main exhaust path 10. The gas introducing system 6 is provided with valves 61, 62 which may be opened and closed independently of each other. At a location upstream of the valves 61, 62, a gas cylinder 17 is connected for supplying a reactive gas therefrom. The gas exhaust system, in turn, comprises the main exhaust path 10 and a bypass exhaust path 33, each of which has its extreme end connected to an exhaust pump 7.

The box-like electrode 5 is also connected with the main vacuum chamber 12 through the insulating layer 15. The insulating layer 15 is provided for blocking the main vacuum chamber 12 from a high voltage when the disk substrate 1 and the holder 2 are introduced into the electrode 5 through the access port 8 so as to prevent a plasma from being generated in the main vacuum chamber 12. The main vacuum chamber 12 is connected to the exhaust pump 7.

One feature of the present invention lies in the structure of the electrode 5. The electrode 5 is formed of a plain continuous uniform film and is applied with a high-frequency high voltage from the single power supply 13 such that the entire electrode 5 is held at substantially the same potential. Stated another way, the inner wall of the plasma processing chamber 4 is entirely covered with the electrically connected metal electrode 5 except for the substrate 1 and the holder 2. Inside the electrode 5 covering the inner wall of the plasma processing chamber 4, a plasma is generated in such a manner that substantially a uniform potential prevails over the surfaces of the disk substrate 1. This results in removing a potential difference of the plasma on one and the other surfaces of the disk substrate 1 as well as preventing the plasma from concentrating in end portions of the disk substrate 1. Further, an inner wall layer 11 made of an insulating material is provided on the inner surface of the electrode 5 for preventing a film deposited on the inner wall of the electrode 5 from peeling as well as foreign substances from being produced due to abnormal discharge. A material for the inner wall layer 11 may be polyimide or insulating SiC, details of which will be described later.

The characteristics of the electrode 5 will be described in more detail with reference to Fig. 2. In Fig. 2, plasma portions 18, 19 are indicated by hatching. Reference numeral 18 designates a plasma portion coupled outside the disk substrate 1, and 19 a plasma portion coupled within the hole of the substrate 1. The electrode 5 surrounds the entire disk substrate 1 and is supplied with a high-frequency high voltage so as to generate a plasma which substantially covers the entire surfaces of the disk substrate 1. The term "substantially" is used herein because the disk substrate 1 includes in practice a contact portion with the holder 2, and this contact portion is excluded from the surface of the disk substrate 1 covered with the plasma. The contact portion should be the smallest possible as long as it does not cause troubles in holding and carrying the disk substrate.

Another feature of the present invention is in an improvement of the gas exhaust system. More specifically, a slit-like outlet of the chamber is connected to the main exhaust path 10 through a plasma blocking member 9, so that a reactive gas flows through this main exhaust path 10 to the pump 7 during normal plasma processing. In addition, the bypass exhaust path 33 is branched from the main exhaust path 10 at an opening 331 and is provided with a valve 32 which can be opened and closed in the directions indicated by the arrows b. As a feature of the exhaust system, a portion of the high voltage electrode 5 constitutes as it is as a part of the valve 32. This structure prevents a plasma from leaking to the exhaust system during the formation of a film on the substrate 1 to cause degraded plasma processing effects. The valve 32 and the bypass exhaust path 33 are provided for rapidly exhausting gas remaining within the plasma processing chamber 4 after completing the formation of a film on the substrate 1. This is effective in improving the productivity of disk substrates, i.e., when a large number of disk substrates are successively processed.

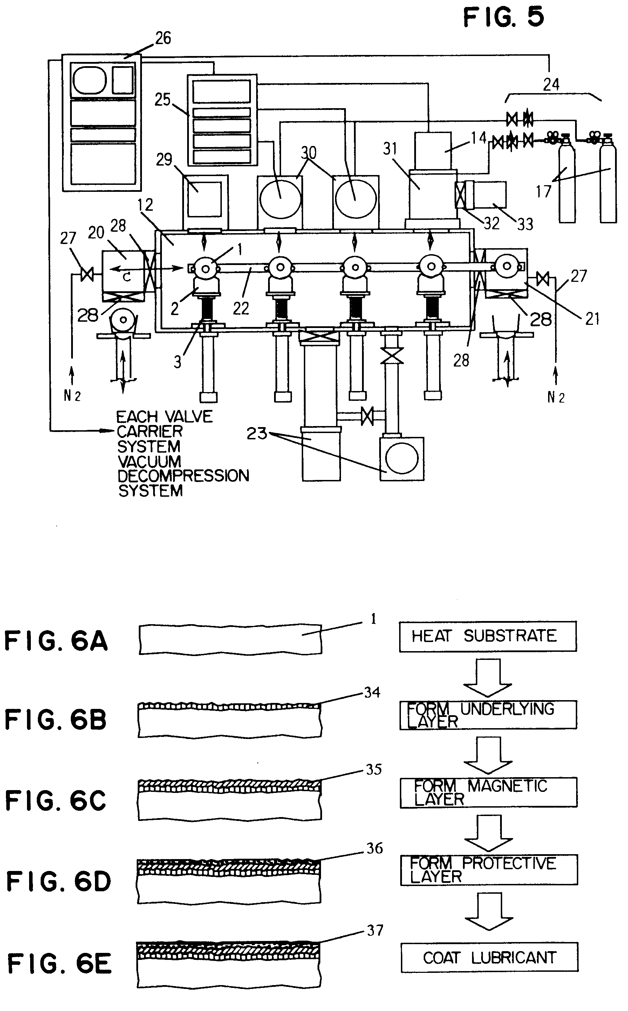

More detailed explanation is now given of how to accomplish a reduction in time required to exhaust a reactive gas from the plasma processing chamber 4. Normally, while the substrate 1 is subjected to the plasma processing in the plasma processing chamber 4, the reactove gas within the processing chamber 4 is flowing little by little through the plasma blocking member 9 to the main exhaust path 10. Then, as the formation of a film on the substrate 1 is completed, the plasma is forced to disappear and the valve 61 is closed to interrupt the supply of the reactive gas. Next, as the valve 32 is opened in the direction indicated by the arrow b, the reactive gas remaining within the processing chamber 4 is exhausted at a stroke to the bypass exhaust path 33, and passes to the main exhaust path 10 through the opening 331. In this way, the gas pressure inside the processing chamber 4 can be decreased in a short time. If the exhausting operation does not rely on the bypass exhaust path 33, the reactive gas will be exhausted from the plasma processing chamber 4 only through the main exhaust path 10, thus taking a longer time to completely discharge the gas from the plasma processing chamber 4. In addition, since the substrate is inevitably carried within the main vacuum chamber 12 without sufficiently exhausting the reactive gas, the reactive gas may possibly invade other processing chambers (a processing chamber 30 and so on shown in Fig. 5, later described) through the main vacuum chamber 12, resulting in degrading the performance of the other processing chambers in which the substrate is processed in later stages. For example, if impurities are mixed in a sputtering process for sputtering a magnetic layer onto a disk substrate, the magnetic characteristics of the disk will be deteriorated. The improved exhaust system of the present invention also contributes to an improvement in the performance of the magnetic disk.

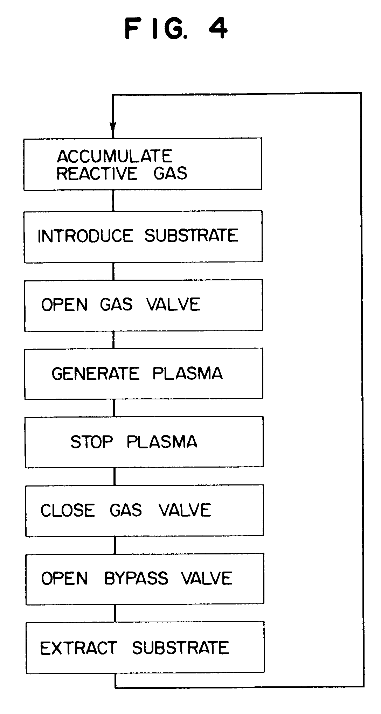

Next, a process of forming a DLC film on a disk substrate using the foregoing plasma processing apparatus will be described with reference to Fig. 4.

It is first assumed that any gas has been discharged from the plasma processing chamber 4. With the valve 62 set in an open state and the valve 61 in a closed state, a reactive gas including hydrocarbon such as methane to be supplied to the processing chamber 4 is accumulated in the gas introducing system 6 from the gas cylinder 17.

A disk substrate 1 is placed in the main vacuum chamber 12, held by the holder 2. In this state, the carrier mechanism 3 drives the holder 2 in the direction indicated by the arrow a to introduce the holder 2 with the substrate 1 from the main vacuum chamber 12 to the plasma processing chamber 4 through the access port 8. It should be noted that the substrate 1 and the holder 2 is at a ground potential.

The valve 61 in the gas introducing system 6 is opened to supply the reactive gas into the plasma processing chamber 4, so that the the inside of the plasma processing chamber 4, i.e., the space around the substrate 1 is filled with the reactive gas.

When the pressure inside the processing chamber 4 has reached a predetermined gas pressure, a high voltage is generated from the high frequency power supply 13 and applied to the electrode 5. A plasma is generated in the plasma processing chamber 4 by the electrode 5 applied with the high-frequency high voltage. In this event, the plasma is generated in such a manner that the substrate 1 is entirely covered therewith, and is held at a positive potential equal to the potential on the substrate 1. Thus, the hydrocarbon gas is decomposed to generate ions and radicals. These reactive species attach to the surface of the substrate 1 and react to each other to form a carbon thin film. The physical properties of the thin film formed here depend on plasma conditions and substrate temperature. To form a hard film, i.e., the so-called DLC film, for example, using methane, the gas pressure may range from 10 to 500 mTorr; a plasma potential relative to the substrate, i.e., a bias voltage from 100 to 1500 volts; and the substrate temperature from a room temperature to 350°C. This is because an excessively low gas pressure, an excessively high bias voltage, and an excessively high temperature would develop the decomposition of the film to result in a graphite-like film, whereas an excessively high gas pressure and an excessively low bias voltage would cause a raw material to remain not decomposed and pile up on the substrate to form a polymeric film containing a large amount of hydrogen.

In particular, a gas pressure of 100 mTorr or more, a bias voltage of 800 volts or less, and a substrate temperature of 300°C or less are preferable for further enhancing the effects of the present invention. This is because an excessively low gas pressure, an excessively high bias voltage, or an excessively high substrate temperature would cause an uneven temperature distribution of the plasma and end portions of the substrate, resulting in a degraded film thickness distribution.

After the DLC film has been thus formed, the plasma is forced to disappear, and the supply of the reactive gas from the introducing system 6 is inhibited.

Thereafter, the valve 32 is driven to open in the direction indicated by the arrow b, to exhaust the reactive gas from the plasma processing chamber 4 to the exhaust path 33 at a stroke.

After the reactive gas has been exhausted for a predetermined time, the carrier mechanism 3 is driven to carry the disk substrate 1 and the holder 2 from the plasma processing chamber 4 back to the main vacuum chamber 12. The disk substrate 1 is then transferred to the next process.

The foregoing operations are repeated each time a disk substrate undergoes the plasma processing. According to one example of the present invention, it takes only ten seconds or less from the time a disk substrate is placed in the plasma processing chamber 4 to the time the disk substrate is extracted from the plasma processing chamber 4 after the plasma processing is completed for the disk substrate. It will be appreciated that the present invention can largely reduce the processing time as compared with the prior art techniques.

To enhance the productivity of substrates, improvements in the gas introducing system should be considered in addition to the improvements in the gas exhaust system. More specifically, as described above, the valve 62 is opened while the valve 61 located closer to the electrode 5 is closed before the substrate 1 is placed in the processing chamber 4, such that a certain amount of reactive gas is accumulated within gas pipes. By opening the valve 61 after the substrate 1 has been carried into the processing chamber 4, the accumulated reactive gas promptly fills the plasma processing chamber 4 to instantaneously increase the pressure inside the plasma processing chamber 4. Then, a mass flow controller is set to a predetermined value to control a gas flow rate at the predetermined value. A process like this lowers the gas pressure to achieve a reduction in cycle time.

Next, an example of a magnetic disk manufacturing apparatus according to the present invention will be described with reference to Fig. 5. The illustrated apparatus is mainly constituted of the main vacuum chamber 12 and a plurality of processing chambers 29 - 31 for performing a variety of processing. More specifically, the main vacuum chamber 12 is coupled to a load chamber 20 for introducing a disk substrate from an atmospheric pressure state to a vacuum state and to an unload chamber 21 for extracting a disk substrate from the vacuum state to the atmospheric pressure state. The manufacturing apparatus also comprises a decompression system 23 for developing a vacuum state in the main vacuum chamber 12, processing chambers 29 - 31, load chamber 20, and unload chamber 21, and a gas supply system 24 for introducing required gases to the processing chambers 29 - 31. Further, the manufacturing system comprises a power supply system 25 for supplying electric power to these processing chambers for their respective processing and a control system 26 for controlling the respective chambers and systems.

The main vacuum chamber 12 is coupled to the respective processing chambers in a vacuum state for carrying therethrough disk substrates to and from the processing chambers. For this operation, the main vacuum chamber 12 is provided with a transfer mechanism 22 for tranferring the disk substrate 1 from the load chamber 20 to the main vacuum chamber 12, and from the main vacuum chamber 12 to the unload chamber 21. Also, for accessing the disk substrate 1 to the respective processing chambers 29 - 31, in other words, for transferring the disk substrate 1 in the direction indicated by the arrow a perpendicular to the transfer direction c by the transfer mechanism 22, carrier mechanisms 3 are provided independently from each other for the respective processing chambers 29 - 31. Each of the carrier mechanisms 3 has the holder 2 at the tip thereof for holding the disk substrate 1. The disk substrate 1 may be held by carrying the same on a supporting tab or a blade provided on the holder 2, or by chucking the same at the outer or inner periphery thereof.

The load chamber 20 serves to introduce the disk substrate 1 from an atmospheric pressure state to a vacuum state and comprises, for example, a vacuum exhaustible container, a vent mechanism 27 for opening to the atmosphere, the vacuum decompression system 23, the transfer mechanism 22, and gate valves 28, one of which separates the load chamber 20 from the atmosphere and the other separates the load chamber 20 from the main vacuum chamber 12.

The unload chamber 21 serves to return the disk substrate 1 from the vacuum state to the atmospheric pressure state, and comprises, for example, a vacuum exhaustible container, a vent mechanism 27 for opening to the atmosphere, the vacuum decompression system 23, the transfer mechanism 22 and gate valves 28, one of which separates the unload chamber 21 from the atmosphere and the other separates the unload chamber 21 from the atmosphere and the other separates the unload chamber 21 from the main vacuum chamber 12.

The processing chambers 29 - 31 are provided for performing their respective particular processing on the disk substrate 1 and include functions in accordance with the respective processing details. Specific processing performed by these chambers are as follows.

A heating chamber 29, which serves to heat the disk substrate 1, comprises a heater usable in a vacuum such as a sheath heater, infrared heater, far infrared heater, or the like.

A sputter chamber 30 consists of an underlying layer sputtering chamber 301 and a magnetic layer sputtering chamber 302 and has targets, made of a metal, alloy or compound, fixed on a pair of cathode electrodes facing one and the other surfaces of the disk substrate 1, respectively, for sputtering the the targets onto the surfaces of the disk substrate 1 to form a thin film on each surface. A correcting member may occasionally be provided for correcting a film thickness distribution, if necessary. The cathodes are usually water-cooled so as not to be heated by a plasma. A planar-magnetron construction incorporating an electromagnet or a permanent magnet is often applied to the sputter chamber 30 because of its capability of forming a film at a higher speed. While a power supply for generating a plasma may be of a D.C. type or an A.C. type, a D.C. power supply is suitable for stably supplying a large current at a low cost. Alternatively, if difficulties in the neutralization of charges causes arc discharge to easily occur, for example, when a target made of an insulating material is used, a high frequency power supply may be utilized.

A CVD chamber 31 serves to form a DLC film on the disk substrate 1. The CVD chamber 31 corresponds to the aforementioned plasma processing chamber 4, so that details of its components such as an electrode, a gas introducing system, a gas exhaust system, and other parts are identical to those described above in connection with the plasma processing chamber 4.

The vacuum decompression system 23 serves to decompresses the main vacuum chamber 12 and the respective processing chambers to a vacuum, and comprises a vacuum pump, a valve, exhaust pipes, a vacuum degree measuring device, and so on. The gas supply system 24, which in turn serves to supply a gas to the respective processing chambers, comprises a gas cylinder 17, a valve, pipes, a regulator, a mass flow controller, and so on.

The power supply system 25 supplies the respective processing chambers 29 - 30 with different voltages in accordance with their respective processing. The control system 26 may comprise, for example, a control computer for controlling the operation of the overall manufacturing apparatus. Specifically, the control system 26 controls the transfer of the disk substrate 1, the supply and exhaust of a reactive gas, and the film forming operations, as well as measures a variety of parameters in the respective processing chambers 29 - 30.

Next, a method of manufacturing a magnetic disk medium will be described in conjunction with the disk manufacturing apparatus shown in Fig. 5. Reference is also made to a flow chart shown in Figs. 6A ∼ 6E representing the magnetic disk manufacturing processes.

First, a disk substrate 1 is set in the load chamber 20. The disk substrate 1 is assumed to have a hole formed in a central portion thereof. A suitable material for the disk substrate 1 may be selected from, for example, aluminum-magnesium alloy substrate covered with a NiP film for a magnetic disk, a glass substrate covered with a metal thin film layer, a plastic substrate, a carbon substrate, and so on. A number of disk substrates 1 are placed in, for example, a transporting cassette (not shown) and set into the load chamber 20. Then, the disk substrates 1 are taken out one by one from the load chamber 20, carried in the direction indicated by the arrow c into the main vacuum chamber 12. Thereafter, the disk substrate 1 undergoes a variety of processing in the respective processing chambers 29 - 31 while carried over the main vacuum chamber 12 by the transfer mechanism 22. The substrate 1 is accessed to the respective processing chambers by the holder 2 driven by the associated carrier mechanisms 3.

Explaining the manufacturing method in greater detail, the disk substrate 1 is received in the heating chamber 29 and heated to a predetermined temperature (cross-section A in Fig. 6A). Immediately after the heating, the disk substrate 1 is carried to an underlying layer sputtering chamber 301, where a non-magnetic underlying layer 34 is formed on the substrate 1 in a predetermined thickness (cross-section B in Fig. 6B). Then, the disk substrate 1 with the underlying layer 34 is carried to a magnetic layer sputtering chamber 302, where a magnetic layer 35 is formed on the non-magnetic underlying layer 34 in a predetermined thickness (cross-section C in Fig. 6C). The magnetic layer 35 may be formed of a composite material, for example, including cobalt/chrome. At this time, the disk substrate 1 as well as the holder 2 is in a conductive state.

The disk substrate 1 is next carried to the CVD chamber 31 (the plasma processing chamber 4 in Fig. 1), where a DLC layer is formed on the magnetic layer 35 of the disk substrate 1 as a protective layer 36 (cross-section D in Fig. 6D). The operation of respective sections in the plasma processing apparatus and the DLC film forming process in the plasma processing chamber 4 have been described in detail with reference to Fig. 4.

Thereafter, the disk substrate 1 is carried to the unload chamber 21 and extracted therefrom. The disk substrate 1 thus formed with a multi-layer film including the magnetic layer 35, the protective layer 36, and so on is next transferred to a process for forming a lubricative layer 37 (cross-section E in Fig. 6E). More specifically, the disk substrate 1 is immersed in perfluoro-polyether group lubricating oil having an absorptive functional group at a terminal dissolved in a solvent, pulled up at a fixed speed, and dried. Consequently, a lubricative layer 37 having a predetermined thickness is formed on the disk substrate 1.

The magnetic disk medium according to the present invention is completed by the formation of the lubricative layer 37. In addition, the disk substrate 1 may be mechanically machined, or formed with an uneven pattern on its surface by a chemical treatment, or cleaned, as required, before the heating process (Fig. 6A). Further, a process for machining the surface of the protective layer may be additionally inserted between the processes D and E.

It will be appreciated from the foregoing that the apparatus or method of the present invention enables a uniform film to be formed by the plasma processing as compared with the prior art techniques. Further effects are expected if the plasma processing condition is optimally controlled.

Specifically, the plasma processing conditions may be selected so as to satisfy the following requirements:
(1) plasmas generated along both surfaces of a disk substrate join with each other outside the substrate and the holder as well as through the hole of the disk substrate;
(2) The area of the joining plasma portion is larger than a combined area of the disk substrate and the holder; and
(3) The cross-sectional area of the plasma joining in the hole of the substrate is larger than one-half of the area of the hole.

To satisfy these conditions, the process gas pressure may be increased and the power be reduced to provide a lower plasma potential. However, a simple increase in gas pressure and a simple reduction in power would result in damaging the effects of the plasma processing. For example, such simple conditioning would hinder a sufficiently hard film from being achieved in the formation of the DLC film or the like. A plasma potential adapted to the embodiment of the present invention is, for example, 100 volts or more, and preferably 300 volts or more. Thus, for satisfying the above-mentioned conditions for forming a DLC film on a 3.5-inch magnetic disk having a central hole with a diameter of 25 mm using methane, the gas pressure should be at least 60 mTorr or more, and preferably 100 mTorr or more.

While a high frequency power supply employed in the present invention is assumed to be such one that supplies electric power at frequencies ranging from 100 kHz to 100 MHz, a commercial high frequency power at 13.56 MHz is preferable from a viewpoint of the industrial use. Also, an oscillating mode may be continuous or pulsatile. While an impedance matching controller associated with the power supply may be selected from a generally used inverse-L type or p type, a blocking capacitor is needed for cutting a direct current component.

When the plasma processing apparatus is used to form a DLC film on a disk substrate, according to the embodiment of the present invention, the following consideration is preferably made on the inner wall layer 11 of the electrode 5 in the plasma processing chamber 4.

Since highly stressed films are gradually deposited on the inner wall surface of the electrode 5 during the formation of DLC films, these films may peel off to contaminate the surfaces of disk substrates while a large number of disk substrates are processed. The contamination would cause a variety of defects in finished disk media. These defects must be eliminated at all costs because they significantly damage the reliability of products. Thus, if peeled films are found, cleaning the interior of the electrode is of prime importance. However, such cleaning, if frequently repeated, would result in increasing the running cost of the manufacturing apparatus and reducing the amount of products. In addition, since the films deposited on the inner surface of the electrode 5 during the formation of the DLC film have an insulating nature, if the film thickness becomes larger, charges will accumulate on the surface thereof, which can cause an instantaneous insulation breakdown. As a result, the electrode 5 would be damaged, and the surface of the substrate under processing and plasma atmosphere would be contaminated if such insulation breakdown occurred during the plasma processing. For preventing such catastrophe, the inner surface of the electrode 5 is preferably covered with an insulating material. For this reason, in the present invention, an insulating layer is formed on the inner surface of the electrode 5 as an inner wall material layer 11. Particularly, in view of the formation of the DLC film, a large effect is expected by selecting a material which couples carbon to exhibit high adhesion. Materials which meet such requirements include the followings:
(1) polymer materials such as teflon, polyimide, polyamide-imide, and so on;
(2) high resistance carbon materials such as glass-like carbon, DLC, and so on; and
(3) carbides such as SiC, MoC, WC, TiC, and so on.

Among these materials, polyimide and insulating SiC are particularly preferable since they exhibit high heat resistance and good adhesion.

Next, changing the subject to a reactive gas for the DLC film formation process of the present invention, materials for the reactive gas available for this purpose may include the following groups:
(1) saturated hydrocarbon group including methane, ethane, propane, n-butane, iso-butane, n-pentane, iso-pentane, neo-pentane, and so on;
(2) unsaturated hydrocarbon group including ethylene, acetylene, propene, propylene, butene, butadiene, and so on;
(3) aromatic hydrocarbon group such as benzene, toluene, xylene, and so on;
(4) cycloaliphatic hydrocarbon group including cyclopropane, cyclobutane, cyclopentane, cyclohexane, adamantane, and so on; and
(5) a mixed gas composed of one of the groups (1) - (4) and one or a plurality of gases selected from hydrogen, helium, neon, argon, krypton, xenon, and so on.

Among these candidates, those having a large molecular weight, double bond, or triple bond are highly reactive and easily change into polymer-like material due to a plasma polymerization reaction. Thus, if these materials are selected, a partial pressure is decreased to slow down the radical reaction in the gas phase in order to form a hard film.

Next, explanation will be given of a lubricant. As described above, a lubricant is coated on the magnetic disk substrate having the multi-layer film formed thereon by a dip method, spin coat method, vapor deposition method or the like. The lubricant for the purpose is preferably perfluoro-polyether having a terminal modified by an absorptive functional group. Particularly, those having a straight-chain structure such as (CF2CF2-O)n-(CF2-O)m- or -(CF2CF2CF2-O)n- are excellent in lubrication. A terminal group may be selected from a variety of functional groups including ester, hydroxyl group, amine group, urea group, amine base, and so on. Additional processing such as removal of foreign substances with a wrapping tape, baking, aging and so on may also be performed after the lubricant is coated.

While representative manufacturing processes for processing a disk substrate have been described above, a variety of other processes such as plasma etching, substrate cooling, and so on may be added as required.

As described above, the manufacturing system and method according to the present invention provide a magnetic disk medium which exhibits better performance as compared with the counterparts of the prior art. An example of the magnetic disk medium manufactured by the present invention will be explained below.

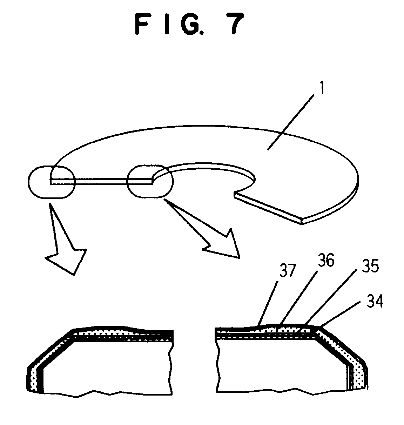

Fig. 7 shows an outer appearance of a magnetic disk medium manufactured by the foregoing embodiment and a cross-sectional structure in outer and inner peripheral portions thereof.

In the prior art DLC film forming method, no film is formed on an end face and chucking portion of a disk substrate to leave a magnetic film to expose in these portions so that these exposed magnetic film portions are susceptible to corrosion and scratches due to contacts. Since large sized disks have predominantly utilized before, and end portions of these disks have been left as unused regions, the corrosion and scratches on the exposed magnetic layer have not developed to a grave problem. However, as smaller sized disks are used, it becomes necessary to utilize the entire areas of both surfaces of a disk as a user area to increase the recording capacity. For this reason, even a scratch in an end portion of a disk could lead to contamination of a recording area by any cause. The present invention provides a solution to this problem by covering the entire disk substrate including end portions, i.e., the inner periphery bordering on the hole and the outer periphery, with a highly durable DLC film as the film designated 36 in Fig. 7.

As shown in the cross-sectional view of Fig. 7, since the present invention can form the film 36 thinner on an information recording area and thicker on the end portions which require high resistance to scratches, a further preferable thickness distribution can be accomplished. The film thickness on the recording area ranges from 3 to 30 nm, and preferably from 5 to 15 nm. A less film thickness exhibits a lower mechanical strength, while a larger film thickness limits a reduction in a gap between a head and a magnetic layer, causing a lower reproduced output. On the other hand, a maximum film thickness on inner and outer peripheral portions is preferably 1.3 times or more the thickness of the film on the recording area. Although an upper limit is not particularly defined in principle, an excessively thick DLC film would exhibit a high film stress and be susceptible to peeling. Therefore, in practice, the film thickness of the DLC film deposited on end portions of a disk substrate is preferably selected to be approximately three times or less the film thickness of the DLC film deposited on the recording area. In addition, the thicker film should not extend beyond the information recording area, i.e., the thicker film should be in practice limited to approximately 1 mm inside the outer periphery.

It should be noted that in the present invention, the thickness of the protective layer refers to an average distance from an average surface of an interface between the underlying layer and the protective layer to an average surface of the protective layer surface, and may be measured, for example, by an X-ray multiple scattering method, or ellipsometry.

Magnetic disks have been actually manufactured using the above described manufacturing apparatus under a variety of different conditions. Specific examples of experiments and the results thereof will be described below.

### (Example 1)

An aluminum-magnesium alloy substrate formed with a Nip hard film for 3.5-inc disks was used as a substrate to manufacture a magnetic disk. Specific manufacturing conditions and results will be described below.

First, the disk substrate was set in the load chamber 20, and the gate valve was closed to decompress the load chamber 20 to a vacuum. Next, the disk substrate was carried to the heating chamber 29, wherein the disk substrate was heated up to 250°C with an infrared heater. Then, the disk substrate was carried to the Co sputtering chamber 302, wherein a CoCrTa magnetic layer was sputter-formed in a thickness of 30 nm on the disk substrate. Next, the disk substrate was carried to the CVD chamber 31. Methane gas was supplied to the electrode 5 at a flow rate of 30 sccm, and the gas pressure within the electrode 5 was set at 150 mTorr by adjusting an exhaust conductance. Then, the high-frequency high voltage power supply 13 was turned on, and an impedance was adjusted to minimize reflected electric power after confirming the generation of of a plasma. As a result, effective power of 500 W was supplied. After the plasma was held for 10 sec in this state, the power supply was turned off, and the supply of the gas was also stopped. After the gas had been exhausted, the disk substrate was extracted from the CVD chamber 31.

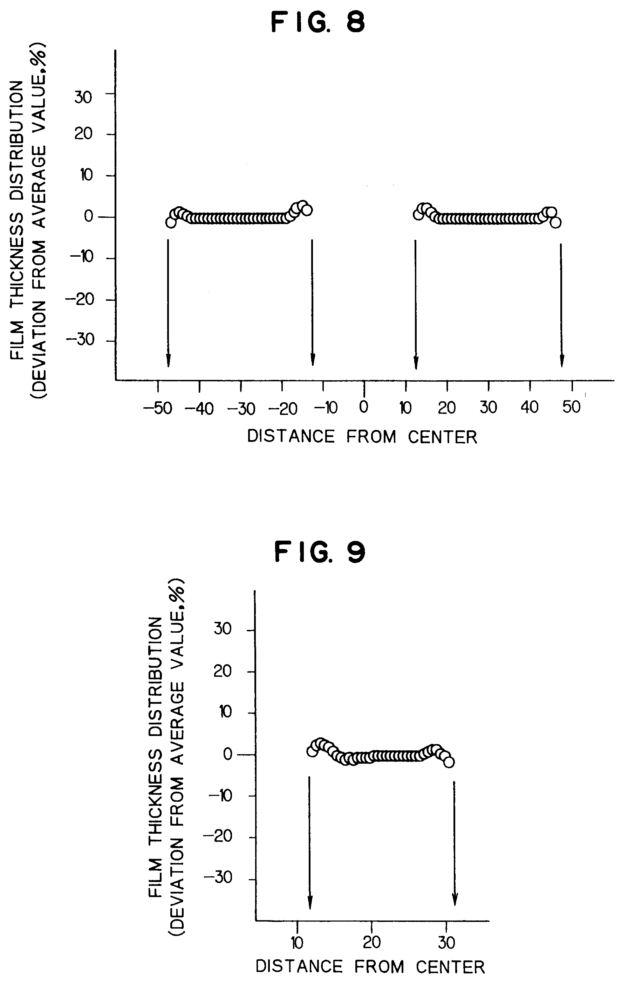

The thickness distribution was measured for a film 36 in the multi-layer film of the magnetic disk substrate thus manufactured. The results show that the film thickness was 22 nm ±0.6 nm on both surfaces of the substrate in a region extending from 2 mm outside the hole of the disk substrate to 1 mm inside the outer periphery, and the distribution included variations of ±3% or less in these regions. Fig. 8 shows a profile of the film thickness in the radial direction R of the magnetic disk substrate.

Finally, the magnetic disk medium was completed by coating a perfluoro-polyether lubricant on the magnetic disk substrate in an average thickness of 1.5 nm by a dip process. Then, the magnetic disk medium thus completed was loaded in a magnetic disk apparatus for writing and reading signals into and from the magnetic disk medium using a magnetic head floating at a height of 50 nm from the disk surface. The results show that fluctuations in read signal magnitude was suppressed to a very small value, i.e., 20% or less over the entire information recording areas on both surfaces of the magnetic disk medium. In addition, when the disk surfaces were observed after the disk medium had been exposed to an atmosphere of 60°C and 80% RH for 72 hours, no apparent corrosion was found, thus exhibiting a good corrosion resistance.

Also, a magnetic disk was formed with a DLC film of 12 nm in thickness in similar processes, and the same evaluations as the above were made therefor. The evaluation results show an increase of 50% in the read signal magnitude and a good corrosion resistance. In a contact start stop test which repeatedly floats and rests a magnetic head on a magnetic disk for evaluating the durability of the magnetic disk, no scratches were observed on both the magnetic head and the magnetic disk after 30,000 times of the repetition. It can be appreciated from the above results that the magnetic disk with a DLC film having a thickness of 12 nm has a practically sufficient durability.

### (Example 2)

Instead of the 3.5-inch disk substrate, a DLC film was formed on a 2.5-inch disk substrate in a similar manufacturing conditions to Example 1. Fig. 9 shows a film thickness distribution of the DLC film formed as a result of this experiment. It can be seen from Fig. 9 that the film thickness is 22 nm ±0.8 nm in a region extending from 2 mm outside the hole of the disk substrate to 1 mm inside the outer periphery, with variations in thickness being ±4% or less. An average difference in thickness on both surfaces was 1.5%. The results of further tests performed on the the 2.5-inch magnetic disk of Example 2 reveal that the magnetic disk of Example 2 has a signal magnitude stability, corrosion resistance, and durability as good as the disk of Example 1.

### (Example 3)

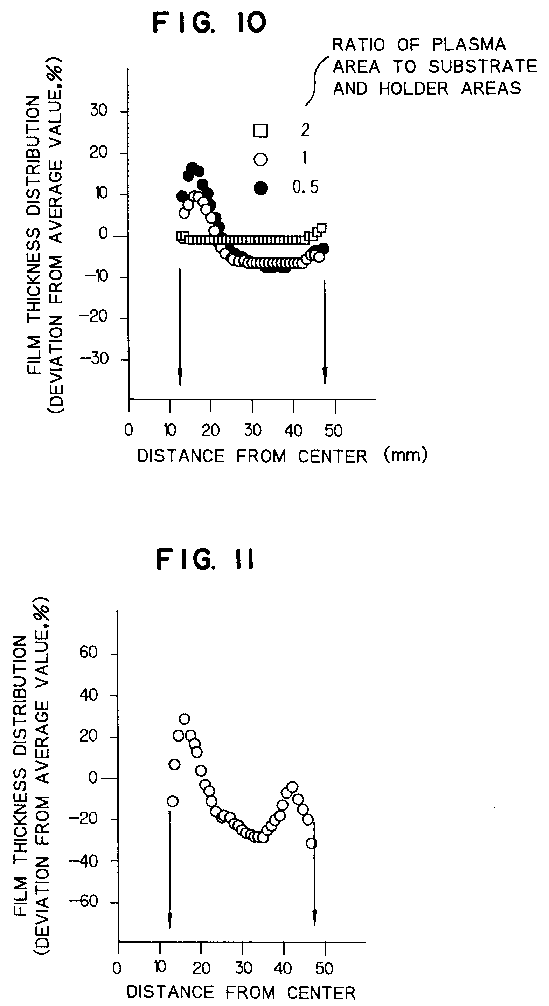

Referring back to Figs. 1 and 2, the same processes as those of Example 1 were executed with different sizes of the electrodes 5 used in the CVD chamber (plasma processing chamber 4) such that a ratio of a combined area of the substrate 1 and the holder 2 to a combined area of plasma portions 18 and 19 is 2.0, 1.0, and 0.5, respectively. Other conditions applied to Example 3 were similar to those of Example 1. Fig. 10 shows film thickness distributions obtained by this experiment. It can be seen from the graph of Fig. 10 that as the ratio of the area of plasma portions to the area of the substrate and the holder is smaller, the film thickness varies or deteriorates. Assuming that the tolerance of film thickness variations in a data recording area is ±10%, it is understood that the area ratio must be one or more.

### (Example 4)

In this example, experiments were made intentionally in an environment not relying on the present invention, in other words, in an environment similar to that used in the prior art, for purposes of comparing the effects of the present invention obtained in the results of Example 1, 2 with the prior art.

More specifically, a rectangular partition plate made of aluminum was prepared for partitioning the plasma processing chamber 4 into right and left portions with the disk 1 and the holder 2 being located on the boundary therebetween. A portion corresponding to the disk 1 and the holder 2 was cut out from the partition plate, and the remaining partition plate is placed on the same plane as the disk 1 and the holder 2. Since the space defined by the electrode 5 is thus partitioned into the left and right portions by the partition plate, the disk 1 and the holder 2, a plasma generated inside the electrode 5 is prevented from extending except for through the central hole of the disk substrate 1, whereby the disk substrate 1 is not surrounded by a uniform plasma. It can be said that this environment is close to that shown in Fig. 6 of the aforementioned JP-A-3-120362 which discloses prior art techniques created by the present inventors and others.

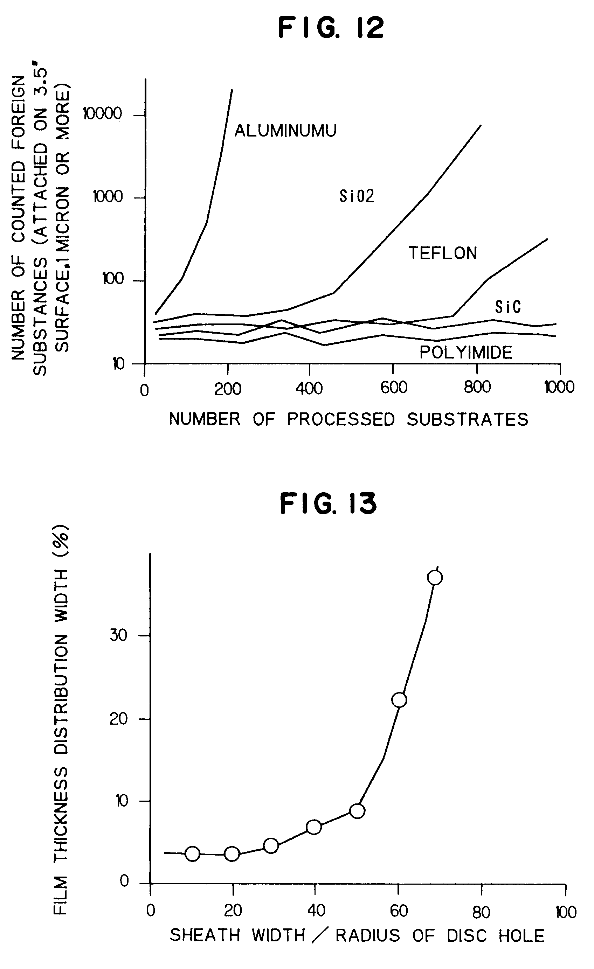

A DLC film was formed on the disk substrate in the above-mentioned environment under conditions similar to those applied to Example 1. Fig. 11 shows a film thickness distribution of the DLC film resulting from this experiment. It can be seen from Fig. 11 that the film thickness was 27 nm ±6 nm in a region extending from 2 mm outside the hole of the disk substrate to 1 mm inside the outer periphery of the same, that the film thickness distribution varied by ±20% or more, and that the film thickness was abruptly increased particularly in an inner peripheral portion of the disk substrate 1. In addition, an average film thickness difference is also increased to 15%.

The final magnetic disk was completed by coating a perfluoro-polyether lubricant on the magnetic disk substrate in an average thickness of 1.5 nm by a dip process. Then, this magnetic disk was loaded in a magnetic disk apparatus for writing and reading signals into and from the magnetic disk using a magnetic head floating at a height of 50 nm from the disk surface. The results show that fluctuations in read signal magnitude amounted to 100% or more. A particularly week signal magnitude was observed in a thicker film portion, thus degrading the reliability. Further, the results of a corrosion resistance test similar to that made to Example 1 reveal that dotted corrosion occurred over an entire circumferential region extending 1.5 mm from the end face of the magnetic disk. Scratches have also been found in an end portion of the magnetic disk, and dotted corrosion along the scratches. It is further revealed that the thickness of the DLC film in the end portion was less than that in the data recording area by 30% - 60%.

It can be understood from the foregoing that the magnetic disk formed with a DLC film is inevitably susceptible to a variety of defects such as degraded reliability, corrosion of the disk substrate, and so on without relying on the method of the present invention.

### (Example 5)

Inner wall protective layers made of SiO2, teflon, polyimide, and insulating SiC were individually formed on the inner wall of an electrode 5 made of aluminum disposed in the CVD chamber or the plasma processing chamber 4 which was used in Example 1. A large number of disk substrates were sequentially formed with a DLC film in the plasma processing chamber 4 with each of different inner wall protective layers. Fig. 12 shows the relationship between a number of processed disks and a number of foreign particles having a size of 1 micron or more attached on the disk substrates for each of the materials used as the inner wall protective layer. As can be seen from the graph of Fig. 12, the inner wall of the electrode 5 without any protective layer causes foreign particles to attach on the substrates at the highest rate. This is followed by SiO2, teflon, SiC, and polyimide in this order. It can be understood from these results that SiC and polyimide are most suitable in use for the inner wall layer material.

### (Example 6)

A sheath thickness of a disk hole portion was next observed when a plasma was generated at different gas pressures under the same conditions as Example 1. Then, a film thickness distribution for a DLC film was measured in a region extending from 2 mm outside the hole of the disk substrate to 1 mm inside the outer periphery. Fig. 13 shows the relationship between the film thickness distribution and a ratio of the area of the disk hole and the area of the sheath portion. It can be seen from Fig. 13 that the film thickness distribution will be improved by selecting the area of the sheath portion to be one-half or less of the area of the disk hole.

### (Example 7)

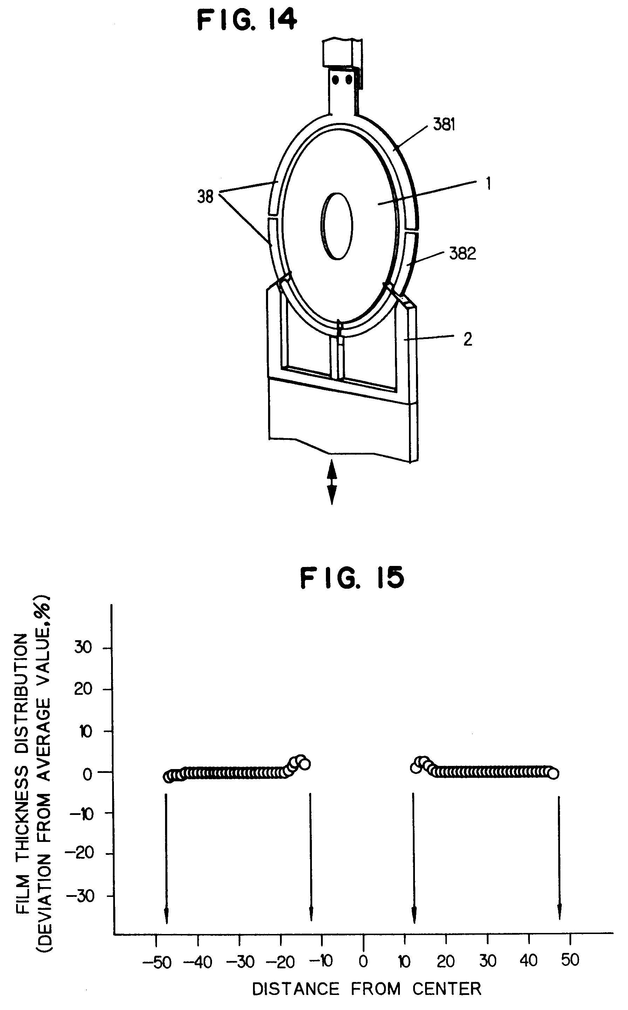

As another embodiment of the present invention, a ring 38 formed of thin annular strap members is disposed along the outer periphery of the disk substrate 1, as shown in Fig. 14, in order to further improve the film thickness distribution of a DLC film particularly in an outer peripheral portion of the disk substrate 1. The ring 38 is divided into upper and lower members 381, 382 for holding the disk substrate 1 in the ring 38 with a predetermined spacing therebetween. The upper ring 381 is secured at an adequate location on the inner wall of the plasma processing chamber 4, while the lower ring 382 is mounted on the holder 2 for the disk substrate 1. At the time the disk substrate 1 is set in the plasma processing chamber 4, the disk substrate 1 is surrounded by the ring 38 over the entire periphery. It can be thought herein that an assembly of the ring 38 and the disk substrate 1 is subjected to the plasma processing. Thus, the ring 38 preferably has the narrowest possible width such that a plasma can extend to the outside of the ring 38. Specifically, the ring 38 may have a width of approximately 2 - 10 mm, by way of example. In addition, the thickness of the ring 38 should be as small as possible, and is preferably close to the thickness of the disk substrate, so as not to disturb an electric field of a plasma. The ring 38 may be held at the same potential as the disk substrate 1, or alternatively may have a floating potential. The latter option is preferable because the potential is not disturbed in an outer peripheral portion so that a DLC film can be formed in a uniform thickness over the disk substrate 1 including the end face. The ring 38 may be preferably made of a material used for the inner wall protective layer for the plasma processing chamber 4, for example, polyimide, insulating SiC, or the like.

Slight gaps formed between the upper ring 381 and the lower ring 382 are preferably not wider than 2 mm. Gaps of such width will not substantially incur any problem. However, excessively wide gaps would cause the formation of a DLC film having a larger thickness on portions of the disk substrate 1 adjacent to the gaps. The essence is that a sufficient space is available outside the ring 38 such that the assembly of the ring 38 and the disk substrate 1 can be surrounded by a plasma.

Since the use of the ring 38 permits the plasma potential to gradually change from the surface of the disk substrate to the ring 38, it is possible to reduce a protrusively formed DLC film in an outer peripheral portion of the disk substrate 1 due to a change in plasma potential.

A DLC film was formed on a disk substrate using the above-mentioned ring under the same conditions as Example 1. Fig. 15 shows a film thickness distribution for the DLC film formed using the ring. As can be seen from Fig. 15, the thickness of the DLC film is made uniform in an outer peripheral portion of the disk substrate. Variations in thickness in a region extending from 2 mm outside the hole to 1 mm inside the outer periphery of the disk substrate is suppressed to ±2% or less. Particularly, in the outer peripheral portion of the magnetic disk, variations in thickness is within ±1%, thus providing substantially a plain surface. As a result, this planified DLC film contributes to reducing fluctuations in reproduced signals in the outer peripheral portion of the magnetic disk to further improve the reliability thereof.

## Claims

1. An apparatus for simultaneously plasma-processing both surfaces of a disk substrate:
a plasma processing chamber (4) having a predetermined internal space in which a disk substrate (1) is placed;
a holder (2) for holding said disk substrate;
means (3) for driving said holder to access said disk substrate to said plasma processing chamber;
means (6, 7) for supplying a reactive gas to said plasma processing chamber;
means (10, 32, 33, 331) for exhausting the reactive gas from said plasma processing chamber;
means (13) for supplying electric power for generating a plasma to said plasma processing chamber; and
a continuous electrode (5) entirely held at substantially the same potential, said electrode disposed to surround said internal space of said plasma processing chamber,
wherein said disk substrate and said holder are held at a ground potential, and a space is established between both surfaces of said disk substrate and said electrode, said space being large enough to generate a plasma therein.

2. A plasma processing apparatus according to claim 1, wherein said exhausting means (10, 32, 33, 331) includes an exhaust valve (331) which is disposed in said plasma processing chamber (4) such that a part of said electrode (5) constitutes an opening of said exhaust valve.

3. A plasma processing apparatus according to claim 1, wherein said supply means (6, 17) supplies a gas including at least hydrocarbon as a reactive gas, and a layer (11) of a material having covalent bonding of carbon is formed on an inner wall surface of said electrode (5) accommodated in said plasma processing chamber (4).

4. A plasma processing apparatus according to claim 3, wherein said layer (11) formed by covalent bonding of carbon is a layer covered with polyimide or insulating SiC.

5. A plasma processing method for simultaneously processing both surfaces of a disk substrate (1) held at a ground potential, comprising the steps of:
introducing the disk substrate into a plasma processing chamber (4);
supplying a reactive gas to said plasma processing chamber;
generating a plasma in said plasma processing chamber and holding said plasma for a predetermined period of time as a plasma enclosed by an electrode (5), said electrode being entirely held at substantially the same potential by a high-frequency high voltage;
exhausting said reactive gas from said plasma processing chamber after said plasma disappears; and
extracting said disk substrate from said plasma processing chamber.

6. A plasma processing method according to claim 5, further comprising the step of opening a bypass exhaust valve (331) before the step of extracting said disk substrate (1) from said plasma processing chamber.

7. A plasma processing method according to claim 5, wherein a gas including at least hydrocarbon is used as said reactive gas.

8. A plasma processing apparatus according to claim 1, further comprising a ring-shaped member (38) having a predetermined thickness which is disposed around the outer periphery of said disk substrate (1) with a predetermined distance therebetween.

9. A plasma processing apparatus according to claim 8, wherein said ring-shaped member (38) comprises first and second ring members (381, 382), said first ring member being secured on the inner wall of said plasma processing chamber, and said second ring member being securely mounted on said holder.

10. A magnetic disk medium having a magnetic layer (35), a protective layer (36), and a lubricative layer (37) on a non-magnetic disk substrate (1), wherein said protective layer is made of diamond-like carbon, said protective layer covering over substantially the entire surface of said disk substrate including end portions, wherein the thickness of said protective layer is 1.3 times or more larger in regions (first regions) within 1 mm from the outer peripheral end and within 1 mm from the inner peripheral end of said disk substrate than in an information recording region (second region) of said disk substrate.

11. A plasma processing apparatus according to claim 1, wherein the size of said electrode (5) is selected such that, in a plane including the center of said disk substrate defined by a plane parallel to the surface of said disk substrate inside said electrode, a total cross-sectional area occupied by the plasma is larger than a total area occupied by said disk substrate and a conductor portion held at the same potential as said disk substrate.

12. A plasma processing method according to claim 5, wherein a diamond-like carbon film (36) is formed under conditions that plasmas generated opposite to both surfaces of said disk substrate join together through a central hole of said disk substrate and around said substrate to extend over an area larger than a combined area of said disk substrate and said holder, and that a sheath thickness between said plasma and said disk substrate is less than one-half of the diameter of the central hole of said disk substrate.

13. A plasma processing apparatus according to claim 11, wherein said conductor held at the same potential as said disk substrate includes at least a holder (2) for holding a disc-like substrate.

14. A plasma processing apparatus for accommodating a body under processing in a processing chamber (4) having a predetermined internal space and for plasma-processing the body under processing, wherein an electrode (5) formed of a continuous film is disposed inside said processing chamber so as to simultaneously hold the entirety of said electrode at the same potential, and said plasma processing apparatus is provided with one power supply (13) for applying a high-frequency high voltage to said electrode.

15. A plasma processing apparatus according to claim 14, further comprising a ring-shaped member (38) having a predetermined thickness which is disposed around the outer periphery of said disk substrate with a predetermined distance therebetween.

16. A plasma processing apparatus for accommodating a subject under processing (1) in a processing chamber (4) having a predetermined internal space and plasma-processing the subject under processing, comprising:
a generator (13) for generating a high voltage at a high frequency;
an electrode (5) formed of a continuous plane member, disposed within said processing chamber, the entirety of said electrode being held at substantially the same potential when a high voltage is supplied thereto from said generator;
a conductive holder (2) for holding the subject under processing, said holder being formed to be held at the same potential as the subject under processing;
a carrier mechanism (3) for carrying said holder for accessing the subject under processing to said processing chamber;
a gas introducing system (6, 17) for supplying said processing chamber with a reactive gas; and
an exhaust system (10, 32, 33, 331) for exhausting said reactive gas from said processing chamber.

17. A plasma processing apparatus according to claim 16, wherein said plasma processing apparatus sequentially processes one by one a plurality of subjects under processing (1), wherein each time one subject under processing is processed, said carrier mechanism (3) accesses the subject under processing to said processing chamber (4), said voltage generator (13) applies said electrode with a high voltage, and said gas introducing system (6, 17) and said exhaust system (10, 32, 33, 331) repeat supply and exhaust of the reactive gas.

18. A plasma processing apparatus according to claim 17, further comprising a layer (11) covered with polyimide or insulating SiC on the inner wall of said electrode.

19. A plasma processing apparatus according to claim 18, wherein said holder (2) supports the subject under processing (1) in contact with the outer periphery thereof.

20. A plasma processing apparatus according to claim 16, wherein said exhaust system (10, 32, 33, 331) includes a main exhaust path (10) which is capable of exhausting the reactive gas even while the plasma processing is under way in said processing chamber (4), and a valve (331) operable to open and close, and a bypass exhaust path (33) having an inside portion constituting a part of said electrode, wherein said valve is opened when the plasma processing is completed to exhaust the reactive gas from said processing chamber.

21. A plasma processing apparatus according to claim 16, wherein said exhaust system (10, 32, 33, 331) includes an exhaust mechanism (331) having at least a valve (331) operable to open and close, said valve constituting a part of said electrode (5), wherein each time the plasma processing is performed on one subject under processing (1), said carrier mechanism (3) accesses the subject under processing to said processing chamber, said high voltage generator (13) applies said electrode with a high voltage, and said gas introducing system (6, 17) supplies the reactive gas while said exhaust system opens said valve to exhaust the reactive gas.

22. A plasma processing method for plasma-processing a subject under processing (1) accommodated in a processing chamber (4), comprising the steps of:
preparing a plasma processing chamber including a cubic electrode (5) formed of a single continuous plane film and a layer (11) of a material having covalent coupling of carbon, said layer formed on the inner wall of said electrode, such that the entirety of said electrode is held at the same potential;
carrying a subject under processing held by a holder (2) into said processing chamber;
supplying a reactive gas to said processing chamber;
generating a high-frequency high voltage from a power supply (13) and applying the high voltage to said electrode;
generating a plasma in said processing chamber and surrounding the subject under processing by the plasma in substantially a uniform state;
forming a film on a surface of the subject under processing;
stopping supplying the high voltage to said electrode;
stopping generating the plasma;
exhausting the reactive gas from said processing chamber; and
extracting the processed subject under processing from said processing chamber.

23. A plasma processing method according to claim 22, wherein said method sequentially performs the plasma processing on a plurality of subjects (1) under processing, wherein said step of carrying a subject under processing into said processing chamber (4) to said step of extracting the subject under processing are repeated each time one subject under processing is processed.

24. A plasma processing method according to claim 22, further comprising the steps of:
heating a disk substrate (1) having a hole in a central portion thereof, said disk substrate being the subject under processing;
setting a gas pressure inside said processing chamber (4) at 10 - 500 mTorr and a bias voltage applied to said disk substrate at 100 - 1500 volts; and
plasma processing said disk substrate to from a diamond-like carbon (DLC) film (36) on said disk substrate.

25. A method of manufacturing a magnetic disk comprising the steps of:
heating a non-magnetic disk substrate (1) having a hole in a central portion thereof;
sputter-forming an underlying layer (34) on said disk substrate;
sputter-forming a magnetic layer (35) on said substrate;
generating a plasma under conditions that a gas pressure ranges from 10 to 500 mTorr and a plasma voltage applied to said disk substrate ranges from 100 to 1500 volts such that a generated plasma surrounds said disk substrate, substantially without producing a potential difference on upper and lower surfaces of said disk substrate in the central hole of said disk substrate and in the vicinity of the outer periphery of the same; and
forming a protective layer (36) on said magnetic layer on the upper and lower surfaces and inner and outer peripheral portions of said disk substrate.

26. A method of manufacturing a magnetic disk according to claim 25, wherein a plasma is generated under conditions that said disk substrate is heated to temperatures ranging from a room temperature to 350°C, the gas pressure ranges from 100 - 500 mTorr, and a plasma voltage ranges from 300 - 1500 volts.

27. A method of manufacturing a magnetic disk according to claim 25, wherein said magnetic disk has information recording regions defined on the upper and lower surfaces thereof, and inner and outer peripheral portions of said disk substrate are formed with a film (36) having a thickness 1.3 times or more larger than a film formed on said information recording regions.

28. A method of forming a film on a plate-like substrate (1) under predetermined conditions with respect to a pressure of a reactive gas and a plasma voltage, comprising the steps of:
generating a plasma under conditions that the gas pressure ranges from 10 to 500 mTorr and a plasma potential applied to said substrate ranges from 100 to 1500 volts;
leaving the generated plasma to surround said substrate, substantially without producing a potential difference on upper and lower surfaces of said substrate in the vicinity of the outer periphery of said substrate; and
forming a layer on the upper and lower surfaces and an outer peripheral end portion of said substrate.

29. A method of forming a film on a plate-like substrate according to claim 28, wherein the outer peripheral end portion of said substrate is formed with a film having a thickness 1.3 times or more larger than a film formed on plane regions on the upper and lower surfaces of said substrate.

30. A magnetic disk medium having at least a magnetic layer (35), a protective layer (36), and a lubricative layer (37) on a non-magnetic disk substrate (1) having a hole in a central portion thereof, wherein said protective layer is made of diamond-like carbon, said protective layer covering over substantially the entire surfaces of said disk substrate including upper and lower surfaces and inner and outer peripheral end portions, wherein the thickness of said protective layer is 1.3 times or more larger in first regions representing the inner and outer peripheral end portions than in a second region representing information recording regions on the upper and lower surfaces of said disk substrate, the film thickness of said second region ranges from 3 to 30 nm, and a film thickness distribution of said protective layer in said second region includes variations in a range of ±4%.

31. The magnetic disk medium of claim 10 or 30 or the method of any of claims 22 to 29, wherein the film thickness of said second region is in a range of 22 nm ±0.6 nm or less.

32. The magnetic disk medium of any of claims 10, 30 and 31 or the method of any of claims 22 to 29 and 31, wherein a film thickness distribution of the protective film formed on said second region includes variations in a range of ±4%.

33. The magnetic disk medium of any of claims 10 and 30 to 32 or the method of any of claims 22 to 29, 31 and 32, wherein:
the thickness of the protective film formed on said first region is 1.3 times or more larger as compared with the thickness of the protective film formed on said second region.

34. The magnetic disk medium of any of claims 10 and 30 to 33 or the method of any of claims 22 to 29 and 31 to 33, wherein an average film thickness difference on the both surfaces of said disk substrate in said second region is 1.5% or less.

35. A method of manufacturing a magnetic disk according to claim 25, wherein said protective layer is made of diamond-like carbon, said protective layer covering over substantially the entire surfaces of said disk substrate including upper and lower surfaces and inner and outer peripheral end portions, wherein the thickness of said protective layer is 1.3 times or more larger in first regions representing the inner and outer peripheral end portions than in a second region representing information recording regions on the upper and lower surfaces of said disk substrate, the film thickness of said second region ranges from 3 to 30 nm, and a film thickness distribution of said protective layer in said second region includes variations in a range of ±4%.
